# EUROPEAN PATENT SPECIFICATION

(11) **EP 1 611 468 B1**
(45) Date of publication and mention of the grant of the patent: **21.05.2008**
(21) Application number: 04758439.6
(22) Date of filing: 26.03.2004
(51) Int. Cl.: G02B 6/42, H01L 31/0203, H01L 31/0232

(54) **PACKAGE FOR OPTOELECTRONIC DEVICE ON WAFER LEVEL**
GEHÄUSE FÜR OPTOELEKTRONISCHES BAUTEIL AUF WAFEREBENE
CHASSIS OPTIQUE MONTE SUR PLAQUETTE

(30) Priority: 26.03.2003 US 457664 P
(43) Date of publication of application: 04.01.2006
(73) Proprietor: Digital Optics Corporation, Charlotte, NC 28262 (US)
(72) Inventor: KATHMAN, Alan, D., Charlotte, NC 28269 (US); MORRIS, James E., Charlotte, NC 28269 (US); HAMMOND, John, Barnett, Charlotte, NC 28216 (US); FELDMAN, Michael, R., Huntersville, NC 28078 (US)
(74) Representative: Jakobsen, Gert Hoey
(86) International application number: PCT/US2004/009383
(87) International publication number: WO 2004/088380

(56) References cited:
- EP-A- 1 130 646
- US-A- 4 873 566
- US-A- 5 011 256
- US-A- 5 926 696
- US-A- 6 104 690
- US-A1- 2002 126 940
- US-B1- 6 249 136

## Description

### BACKGROUND

### Field of the Invention

The present invention is directed to a wafer based optical chassis and associated methods. More particularly, the present Invention is directed to protecting active elements in an optical system and realizing electrical input/output without requiring separate packaging.

### Description of Related Art

Active elements, such as optoelectronic chips, e.g., light sources for transmitters and detectors for receivers, are typically housed in a transistor outline (TO) can. Such a TO can is typically made of metal, has a large form factor, involves an expensive serial manufacturing process and requires active alignment with external passive optical elements. This large form factor separates the active element from an external passive optic along the optical axis, resulting In the passive optic needing to handle a more divergent beam, rendering the optic bigger, thereby further increasing the size of the system. Additionally, the TO can has electrical termination concerns, limiting the speed of the active elements.

Current trends towards miniaturization have spurred numerous small form factor designs. Most of these designs are directed to integrating the passive optical element with some connector, separate from the TO can. While this may reduce the length of the system and simplify the manufacturing of the passive optical portion of the system, the TO can, and the problems attendant therewith, are still present.
EP 1 130 646 A1 discloses a chip mounted enclosure ("CME") comprising a base formed by an integrated circuit chip, a transducer element disposed on the integrated circuit chip, a side piece surrounding the transducer element that is coupled to the base, and a top piece coupled to the side piece. Further, a method of making a CME is disclosed comprising mounting a transducer element to a planar surface of an integrated circuit chip, where the planar surface forms a base of the CME. A side piece is fabricated to surround the transducer element. A top piece of the CME is placed on the side piece. Individual CMEs can be fabricated from a wafer assembly, where transducer elements, each respectively mounted to an integrated circuit wafer having corresponding integrated circuit chips, are individually surrounded by a side piece structure that is bonded to the integrated circuit wafer. Individual CMEs are formed by singulating the wafer assembly.
US 6,104,690 discloses an integrated optical apparatus including an optically transparent substrate with a light source and a detector mounted adjacent thereto. The substrate includes an optical element in a transmit path from the light source to a remote target. The optical element splits the light into more than one beam. A detector receives beams reflected by the target, All optical elements needed to create the more then one beam, direct the more than one beam onto the target and direct the more than one beam from the target to the detector are on the substrate and/or any structure bonded to the substrate. Preferably, the optical element provides sufficient separation between the more than one beam such that each beam is delivered to a unique respective light detecting element of the detector. The return path from the remote target to the detector may include an optical element for each beam or no optical elements. An additional substrate may be included and bonded to the substrate. The active elements may be bonded to a bottom surface of the substrate, either directly or via spacer blocks, or may be provided on a support substrate, which is then bonded, either directly or via spacer blocks, to the substrate.
US 2002/0126940 discloses a structure having an optical element thereon with a portion of the structure extending beyond a region having the optical element in at least one direction. The structure may include an active optical element, with the different dimensions of the substrates forming the structure allowing access for the electrical interconnections for the active optical elements. Different dicing techniques may be used to realize the uneven structures.

### SUMMARY OF THE INVENTION

The present invention is therefore directed to a wafer based optical chassis and associated methods that substantially overcome one or more of the problems due to the limitations and disadvantages of the related art.

It is a feature of the present invention to protect an active element with an assembly including passive optical elements. It is another feature of the present invention to provide efficient electrical coupling to and from the protected active elements. It is yet another feature of the present invention to provide hermetic packaging of an active element that can at least partially be created in parallel. It is yet another feature of the present invention to provide alignment that compensates for variations arising in the manufacturing process.

At least one of the above and other features may be realized by providing an optical apparatus including a mount substrate, an optoelectronic device on the mount substrate, a spacer layer and a sealer layer. The mount substrate, the spacer substrate and the sealer substrate are vertically stacked and hermetically seal the optoelectronic device. The apparatus also includes external electrical contact for the optoelectronic device outside the sealing.

An interior surface of the spacer layer may be angled and have a reflective material thereon. The electrical contact may include a metalized trench. The mount substrate and the spacer layer may be flush. The optical apparatus as may include a ledge formed by differing widths between the mount substrate and the spacer layer. The metalized trenches may be in the ledge or the electrical contact may be on the ledge. The electrical contact may include a conductive via on a bottom surface of the mount substrate and a conductive structure in the via. The conductive structure is a solder ball. The electrical contact may include a conductive material on at least two non-parallel surfaces of the mount substrate.

A passive optical element may be on a surface of the sealer layer. The optical apparatus may include, above the sealer layer, an optical block having a passive optical element on at least one surface thereof. The optical apparatus may include, above the sealer layer, an isolator stack including first and second polarizers and a Faraday rotator sandwiched between the first and second polarizers. The optical apparatus may include, above the sealer layer, another spacer layer. At least two of the mount substrate, the spacer layer and the sealer layer are of materials with approximately same coefficients of thermal expansion. One of the at least two substrates may be silicon and the other may be Pyrex. A terminal surface of the optical apparatus may include a mating feature for mating the optical apparatus with another structure, e.g., a ferrule.

At least one of the above and other features may be realized by providing a method of aligning an active device and a lens, including providing the active device on a mount substrate, the active device having an active area on a side thereof, positioning an angled reflector relative to the active area in accordance with a radius of curvature of the lens, viewing the active area reflected by the angled reflector, and positioning the lens in accordance with the viewed active area.

At least one of the above and other features may be realized by providing a method of creating a plurality of optical apparatuses, including patterning a conductive material on a mount wafer, populating the mount substrate with optoelectronic devices in accordance with the patterning, stacking and securing a spacer layer on the mount wafer, stacking and securing a sealer layer on the spacer layer, wherein the stacking and securing of the spacer layer and the sealer layer on the mount wafer hermetically seal the optoelectronic devices, and vertically separating the mount wafer to form the plurality of optical apparatuses. The vertically separating including exposing a portion of the conductive material outside the hermetic seal. Each optical apparatus includes a mount substrate, an optoelectronic device, a spacer layer, a sealer layer, and exposed conductive material.

The stacking and securing of the sealer substrate to the spacer occurs before stacking and securing of the spacer stacked to the mount substrate.

### BRIEF DESCRIPTION OF THE DRAWINGS

The above and other features and advantages of the present invention will become readily apparent to those of skill in the art by describing in detail embodiments thereof with reference to the attached drawings, in which:

FIG. 1 is an elevational perspective view of an embodiment of the optical chassis of the present invention;

FIG. 2 is a detailed elevational perspective view of the optoelectronic devices and electrical interconnections of the optical chassis of FIG. 1;

FIG. 3 is an elevational perspective exploded view of the wafer components to be used to create the optical chassis of FIG. 1;

FIG. 4 is an elevational perspective view of the passive optical element wafers of FIG. 3 secured together;

FIG. 5 is an elevational perspective view of the active element wafer to be bonded to the stack of wafers in FIG. 4 and then vertically separated to form the optical chassis of FIG. 1;

FIG. 6 an elevational perspective view of a comparative example of an optical chassis not according to the present invention;

FIG. 7 is a detailed perspective bottom view of the electrical interconnections of the optical chassis shown in FIG. 6;

FIGs. 8a-8d are schematic drawings illustrating creation and use of an electrical connection on the face of a substrate;

FIG. 9 is a schematic side view of another embodiment of electrical connections for the optical chassis;

FIG. 10 is a schematic side view of the optical chassis with a larger optical element bonded thereto:

FIG. 11 is a schematic side view of the optical chassis in a common housing with a larger optical element;

FIG. 12A is a schematic cross-section of a specific configuration of the optical chassis of the present invention inserted in a system;

FIG. 12B is a schematic cross-section of the specific configuration of the optical chassis of FIG. 12A alone;

FIG. 13A is a schematic top view of alignment of the active optical element to the mirror;

FIG. 13B is a schematic side view of alignment of the active optical element to the mirror;

FIG. 14A is a schematic top view of alignment of the active optical element to the optics block; and

FIG. 14B is a schematic bottom view of alignment features of the optics block.

### DETAILED DESCRIPTION OF THE INVENTION

The present invention will now be described more fully hereinafter with reference to the accompanying drawings, in which exemplary embodiments of the invention are shown. The invention may, however, be embodied in different forms and should not be construed as limited to the embodiments set forth herein. Rather, these embodiments are provided so that this disclosure will be thorough and complete, and will fully convey the concept of the invention to those skilled in the art. In the drawings, the thickness of layers and regions are exaggerated for clarity. It will also be understood that when a layer is referred to as being "on" another layer or substrate, it may be directly on the other layer or substrate, or intervening layers may also be present. Further, it will be understood that when a layer is referred to as being "under" another layer, it may be directly under, or one or more intervening layers may also be present. In addition, it will also be understood that when a layer is referred to as being "between" two layers, it may be the only layer between the two layers, or one or more intervening layers may also be present. Like numbers refer to like elements throughout.

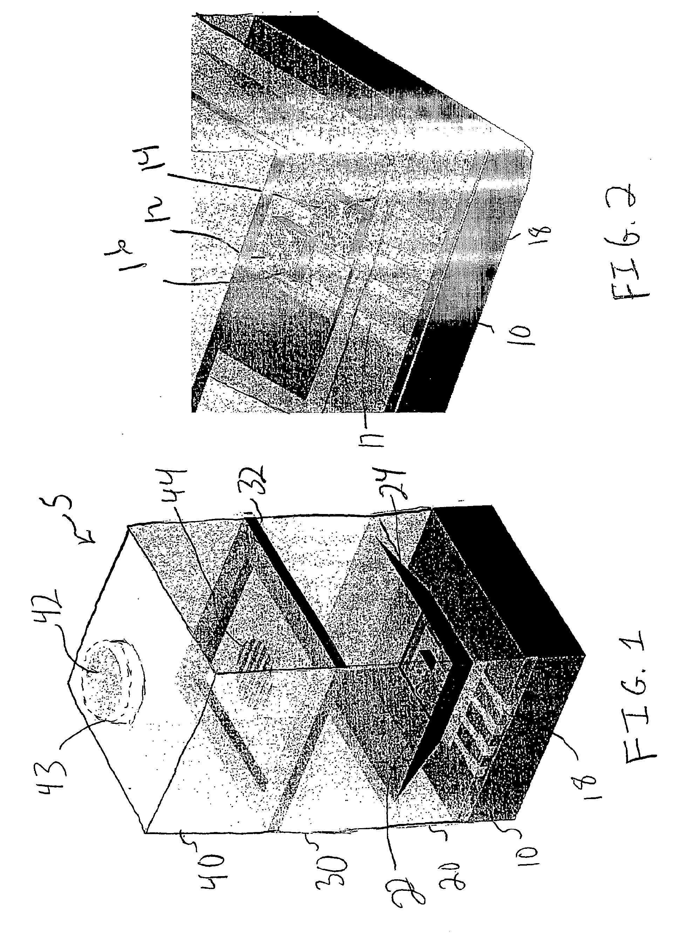

FIG. 1 shows an embodiment of an optical chassis 5 of the present invention having four substrates or layers. These four substrates or layers include a mount substrate 10, a spacer layer 20, a sealer layer 30 and an optional optics substrate 40. The mount substrate 10 serves as a mount for optoelectronic devices, here a light source 12 and a power monitor 14, and provides the electrical interconnections, here including a wire bond 16, conductive patterns 17 and metalized trenches 18. The conductive patterns 17 each include a pad for the wire bond 16 and connect the pad to the trench 18 for external communication. The conductive patterns 17 may be created by patterning conductive material on the mount substrate 10 in a known manner. The trenches 18 may be created by removing a portion of the mount substrate 10 in a conventional manner and filling this portion with conductive material. The conductive material for the trenches 18 may be provided at the same time the conductive patterns 17 are formed. The details of the mount substrate 10 can be seen more clearly in FIG. 2.

The spacer layer 20 provides room for the beam output from the light source 12 to expand. If the optoelectronic device 12 does not have its active area on its top face, e.g., an edge emitting laser, an appropriate portion of a sidewall 22 of the spacer layer 20 may be angled and coated with a reflective coating to appropriately direct the beam in the optical chassis 5. A hole 24 in the spacer wafer 20 may be formed by etching a silicon wafer, producing the characteristic angled sidewall 22 from such an etch. The spacer layer 20, in conjunction with the sealer layer 30, hermetically seals and protects the optoelectronic devices 12, 14 from the environment. The sealer layer 30 may also include an optical element on either surface thereof, e.g., an optical element which reduces the divergence of the beam output from the light source 12.

The optional optics substrate 40 includes at least one optical element. Here, a diffractive optical element 44 on a first surface of the optics substrate 40 directs some of the light from the light source 12 to the power monitor 14, as disclosed, for example, in commonly assigned U.S. Patent No. 6,314,223 entitled "Diffractive Vertical Cavity Surface Emitting Laser Power Monitor and System." An optical coupling element 42 on a second surface of the optics substrate 40 may couple the light between the optoelectronic device, here the light source 12, and further applications, e.g., a fiber. Of course, more than one functionality may be incorporated into each optical element.

If an optical element is to be provided on one or both of the surfaces of the optional optical substrate 40 or the sealer layer 30 adjacent to one another, a separation feature 32, e.g., an indentation or stand off, may be provided on either the sealer layer 30 or the optional optics substrate 40 to insure proper functioning of the optical element. The sealer 30 is transparent. The sealer layer 30 may be glass or may be some other transparent material that closely matches the coefficient of thermal expansion of the layer substrate 20, e.g., Pyrex when the spacer substrate is silicon. The smaller size of the chassis 5, e.g., roughly 2mm by 2mm in x and y, also helps with any thermal mismatch, since there is not a lot of strain placed in the securing joints between the substrates.

Finally, when the optical chassis 5 is to be joined with another device, mating features may be provided on a terminal surface thereof. For example, if the optical chassis is to be mated with a fiber optic ferule, a standoff 43 encircling the optical element 42 may be provided. The standoff 43 may be SU-8 and provides both alignment of the optical chassis 5 with additional devices and provides separation of the optical element 42.

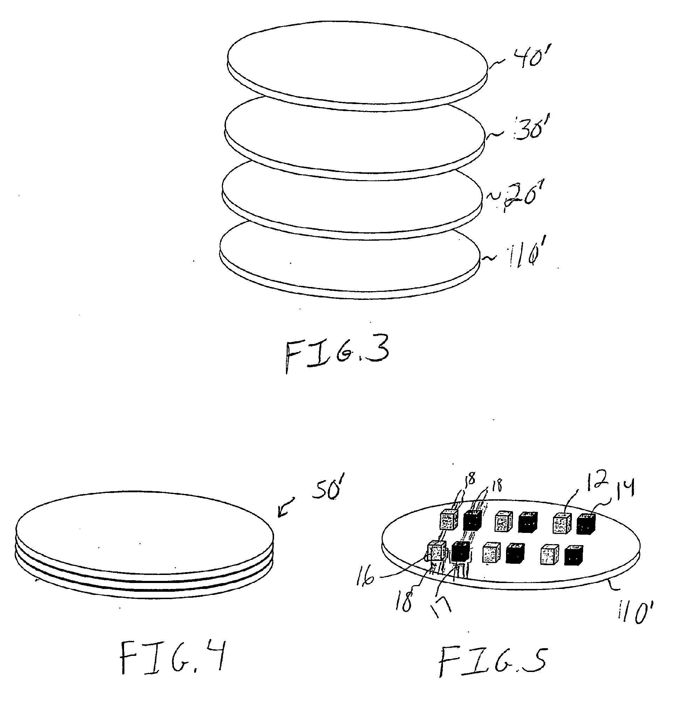

As can be seen from the profile of the optical chassis 5, a plurality of each of these substrates may be created on a wafer level, secured together with other substrates in a vertical stack, and then vertically separated to form a plurality of individual optical chassis 5. As shown in FIG. 3, a mount wafer 10', a spacer wafer 20', a sealer wafer 30' and an optional optics wafer 40' are to be aligned and secured together on a wafer level. Each of these wafers includes a plurality of the respective mount substrates 10, spacer layers 20, sealer layers 30 and optional optical substrates 40. The top three wafers 40', 30' and 20' may be created completely on a wafer level in known fashions. These wafers may then be secured together as shown in FIG. 4 forming a secured stack wafer 50'. These wafers may be aligned and secured as set forth, for example, in U.S. Patent No. 6,096,155 entitled "Method of Dicing Wafer Level Integrated Optical Elements."

For the mount wafer 10', a plurality of metalized trenches 18 for providing the electrical interconnections may be formed on the wafer level. The optoelectronic elements 12, 14 may then be positioned on the mount wafer 10', e.g., using pick-and-place techniques, and then wire bonded 16 to the metalized trenches 18. The metalized trenches 18 may extend along the mount wafer 10', so the separation of the mount wafer 10' will expose the metal on the edge of the mount substrate, as can be seen in FIGS. 1 and 2. The secured stack wafer 50' is then secured to the mount wafer 10' and then vertically separated to form a plurality of optical chassis 5 as shown in FIG. 1. Alternatively, the secured stack wafer may be vertically separated to form secured stack substrates, which are then bonded to the mount wafer 10'.

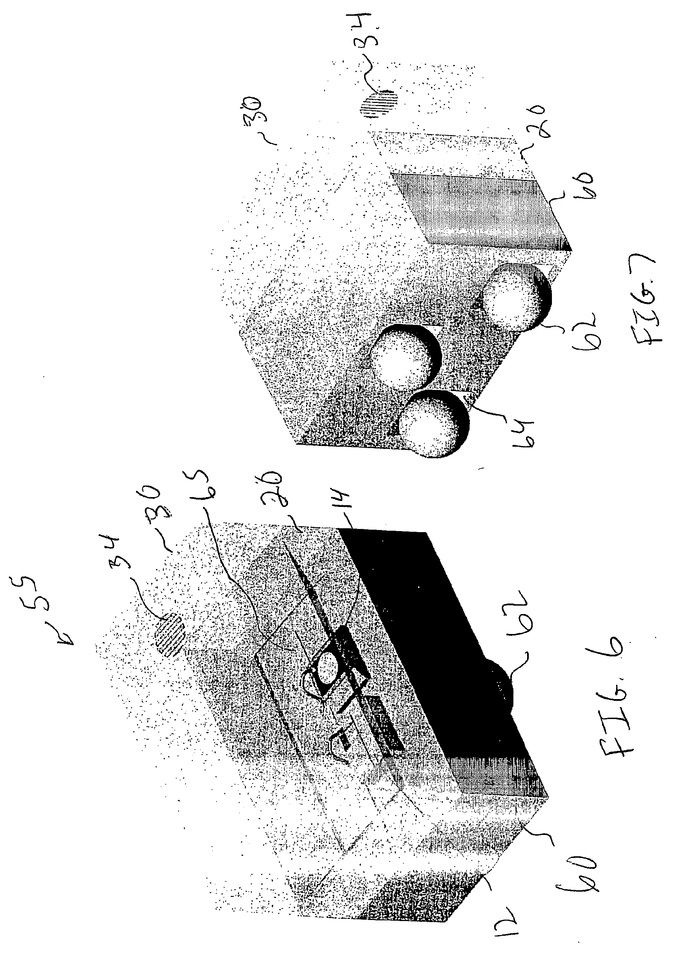

A comparative optical chassis 55 is shown in FIGS. 6 and 7. Here, the optional optical substrate 40 is not included. Only a diffractive optical element 34 for power monitoring and/or efficient coupling is provided on the sealer layer 30. The spacer layer 20 is the same as in FIG. 1. The mount substrate 60 provides different electrical connections as in FIG. 1 for the light source 12 and the power monitor 14. Here, the optoelectronic devices are again wire bonded, here to conductive pads 65. Then, on the bottom of the mount substrate 60, conductive, e.g., metalized, through holes or vias 64 and conductive structures 62, e.g., solder balls, are used to provide the electrical interconnections to the optical elements on the top surface of the mount substrate 60. These conductive structures must be large enough to obscure the hole in the mount substrate to insure the hermetic seal, to avoid creating a thermal gradient and to avoid extra oxidation. This solution is particularly useful if the mount substrate is a ceramic, since it is expensive to put solder on ceramic.

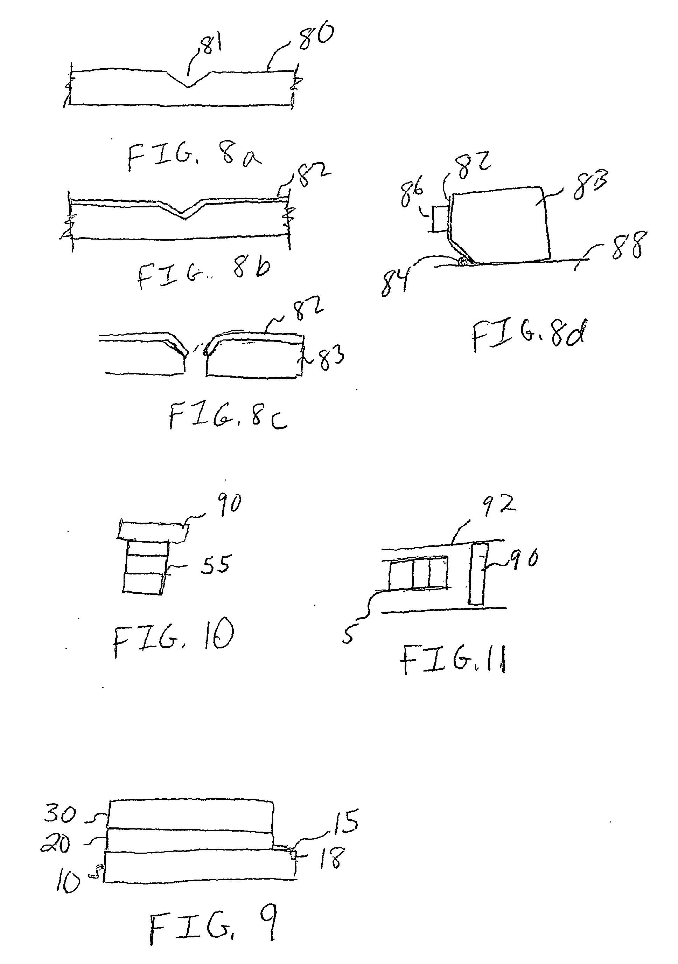

Another alternative for providing electrical interconnections to the optoelectronic element on a wafer level is shown in FIGS. 8A-8D. As shown in FIG. 8A, a saw or other etching device is used to produce V-shaped groove 81 in a wafer 80. Then, the groove 81 and the wafer 80 are coated with an electrically conductive coating 82, e.g., metal, as shown in FIG. 8B. Then, the wafer 80 is separated at the V-groove 81 and at another portion to form a mount substrate 83, as shown in FIG. 8C. The groove 81 needs to be wide enough so that an angle remains after separation. For example, if dicing is used as the separation technique, the groove will need to be wider than the blade width of the dicing saw.

As shown in FIG. 8D, an optoelectronic device 86 is mounted on the conductive coating 82 of the mount substrate 83. A solder ball 84 or other conductive structure may then used to connect the conductive coating 82 to an electrical connection on a board 88. The other substrates or layers 20, 30 and optionally 40 may be stacked over the mount substrate 83 as shown in the other configurations.

Electrical input/output may also be realized as shown in FIG. 9, in which the substrates forming the optical chassis do not have the same width, thereby forming a ledge 15, with the electrical connection being realized on a portion of the chassis 5 providing the ledge 15. As shown in FIG. 9, the ledge 15 may be formed by having the mount substrate 10 extend further in at least one direction than the adjacent spacer layer 20. The electrical contacts may be formed on the surface of the ledge or a portion of the ledge 15 may be removed to form the trenches 18 therein to increase the surface for electrical contact.

Such a ledge may be formed by die bonding a secured stacked substrate having the spacer layer 20 and the sealer layer 30 to the mount substrate 10. Forming such a ledge on wafer level may be realized in a number of manners, including using dicing saws of different thicknesses and dicing through opposite surfaces, e.g., flipping the wafer after partial dicing, of the secured stacked wafer, including the mount wafer 10'.

If customized performance of the optical chassis is known, optional optical substrate(s) may be incorporated to provide the desired performance. Otherwise, the optical chassis of the present invention may be used to simply replace the conventional TO-can element and can have the conventional optics aligned thereto, as is currently done for the TO-can optoelectronics. Two manners of achieving this are shown in shown in FIGs. 10 and 11. As shown in FIG. 10, the vertically integrated optical chassis 55 of the present invention may have an optical element 90, including optical elements larger in the x- and/or y-direction than the optical chassis 55, die-bonded thereto. As shown in FIG. 11, the optical element 90 may be separate from but aligned with the optical chassis 55, here shown in a common housing 92. This separation reduces the alignment tolerances for the optical element 90. The sealer layer 30 may still include optics thereon for improving the light from the light source 12, e.g., collimating or at least reducing the divergence of the light.

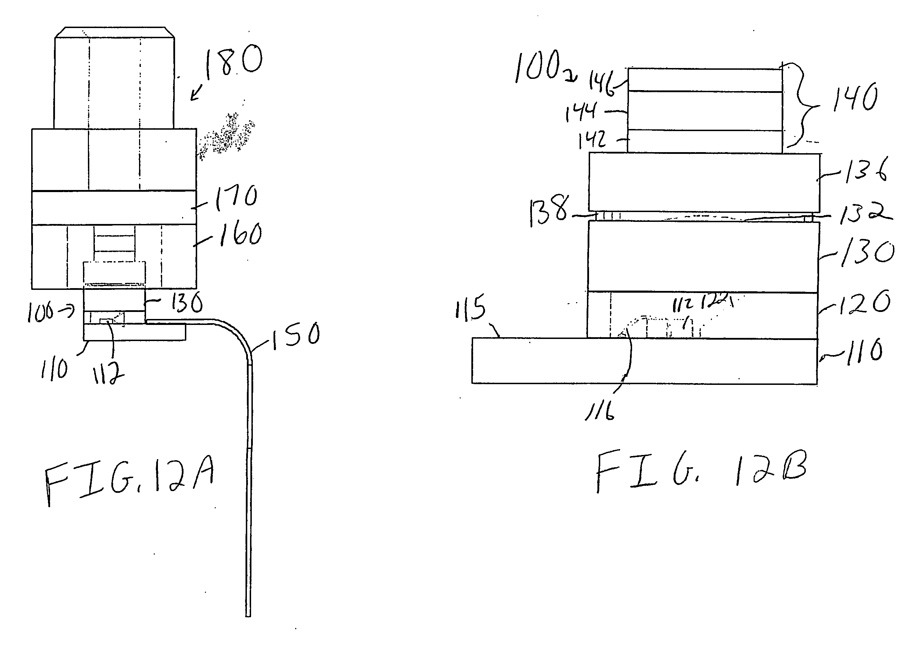

A specific configuration of an optical chassis in accordance with the present invention is shown in FIGS. 12A-12B. As can be seen therein, an optical chassis 100 is attached to a flex lead 150, inserted into a magnet 160, on which a fiber stop 170 and then a fiber sleeve 180 is secured. This structure may be provided on a heat sink.

The optical chassis 100 includes a mount substrate 110 having a ledge 115, a spacer substrate 120 and a sealer substrate 130. An optoelectronic device 112 and wire bonds 116 are on the mount substrate 110. The sealer layer 130 includes a lens 132 and an angled, reflective sidewall 122. The angled, reflective sidewall 122 serves as a mirror to direct light between the optoelectronic device 112 and the fiber in the fiber sleeve 180. If the active area or facet of the optoelectronic device is not on an edge thereof, this angled, reflective sidewall 122 is not needed.

An additional spacer layer 136, which may include additional spacing structures 138, separates the lens 132 from an isolator stack 140. The spacing structures 138 are used when a passive optical element is on one or more opposing surfaces in the stack and the surfaces would otherwise be flush at the passive optical element. The spacing structures may be integral with the surface or may be provided on the surface. Alternatively, these spacing structures may be on the sealer 130. The electrical connection of the optoelectronic device 116 is realized using the ledge 115, as discussed in connection with FIG. 9.

The isolator stack 140 includes a first polarizer 142, a Faraday rotator 144 and a second polarizer 146. The magnet 170, which may be a ring magnet, surrounds the isolator stack 140 when the optical chassis 100 is inserted as shown in FIG. 12A, thereby completing the isolator. If the Faraday rotator 144 is a latching type, then the speared magnet 170 is not needed.

In any of the above configurations, the active elements are secured to the mount substrate such that they remain secured and withstand subsequent processing, e.g., the securing of the substrate. The construction of the optical chassis of the present invention needs to be determined in an appropriate order, with the least robust technique being performed last. The materials used for the securing of the active elements, realizing the electrical connections and the securing of the substrates must be selected in accordance with the required order. For example, the active elements may be secured on the mount substrate using a gold-tin (AuSn) solder and the substrates may then be secured using a material with a lower melting point, e.g., silver-tin (AgSn) solder.

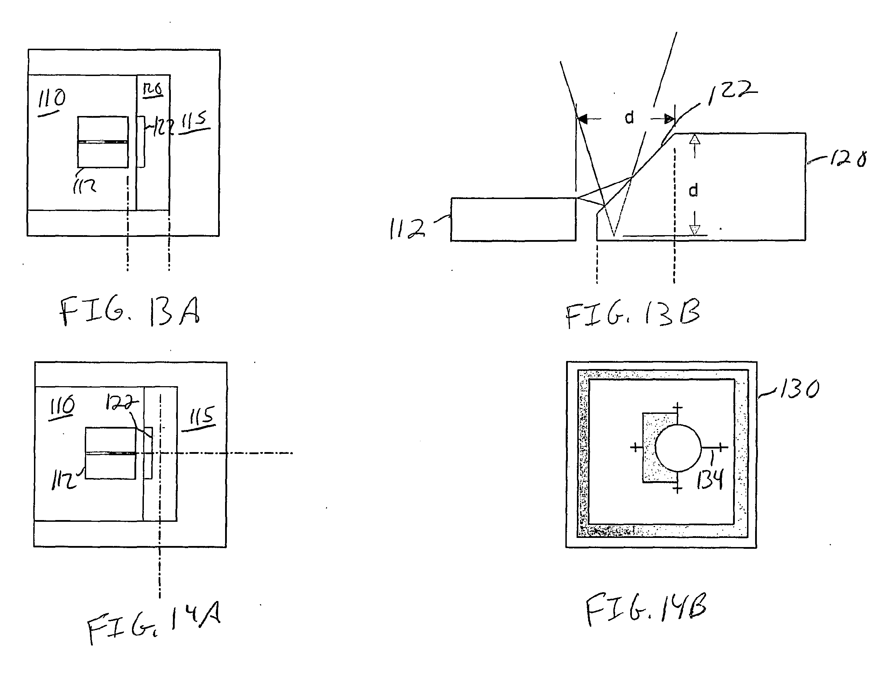

Techniques for realizing alignment of the optical elements in the optical chassis are shown in FIGS. 13A-14B. In making micro-optical elements, there are inevitable variations in characteristics, e.g., lens thickness, radius of curvature (ROC), of individual elements. By classifying these lenses by their ROC into different groups within a range, e.g., ±1%, the variation in ROC may be compensated for with the placement of the angled surface 122 of the spacer substrate 120, as shown in FIG. 13A-13B. Once a lens is selected for a particular optoelectronic device 112 on the mount substrate 110, the separation d between the optoelectronic device 112 and a back edge of the angled surface 122 is determined in accordance with the ROC of the lens to be used. If the angled surface 122 has an angle of approximately 45°, this distance d will be roughly equal to the height of the spacer layer 120. Thus, this aligning of the optoelectronic device 112 with the angled surface 122 compensates for any variations in the thickness of the spacer layer 120, as well as taking the ROC of the lens into account.

The aligning of the lens to the optoelectronic device 112 is shown in FIGS. 14A-14B. Here, the image of the active area of the optoelectronic device 112 in the reflective angled surface 122 may be used to align the lens. A bottom surface of the substrate having the lens thereon, which may be the sealer layer 130 as shown in FIGS. 12A-12B, includes alignment features 134, here in the form of a crosshair centered on the lens on the top surface of the substrate. The alignment features 134 are then centered with the image of the active area of the optoelectronic device 112 as reflected by the angled surface 122 to insure proper alignment there between. Since the height of the optoelectronic element changes its location on the angled surface 122, by aligning the lens to the reflection from the angled surface 122, variations in the height of the optoelectronic element may be compensated for as well.

If the active area of the optoelectronic device 112 is not on a side thereof, the lens may be aligned by directly viewing the active area using alignment features 134. The variation in height of such optoelectronic devices, i.e., in the z-direction, do not significantly affect the performance. If there are no optical elements on the sealer substrate 130, the alignment thereof is not critical. Since the sealer layer 130 is transparent, alignment features do not need to be provided thereon, as alignment features on surfaces below the sealer substrate may be viewed through it. If there are optical elements on other substrates, and the sealer layer 130 is transparent, the same alignment techniques may be employed.

Thus, in accordance with the present invention, an optical chassis having a small form factor may be created at least partially on a wafer level, including electrical interconnections. The optical chassis of the present invention also provides a hermetic seal without requiring a TO can or other separate housing. Further, since substrates of the optical chassis are secured to one another, rather than to a carrier as in a TO can, better alignment can be maintained for longer.

While the present invention is described herein with reference to illustrative embodiments for particular applications, it should be understood that the present invention is not limited thereto. Those having ordinary skill in the art and access to the teachings provided herein will recognize additional modifications, applications, and embodiments within the scope of the invention as defined in the appended claims. For example, any of the electrical interconnections shown may be used with any optical chassis embodiments. Further, additional optical substrates or elements as needed may be secured to the optical chassis. Finally, any of the configurations of the optical chassis may be created at least partially on a wafer level as discussed regarding FIGS. 3-5.

## Claims

1. An optical apparatus, comprising:
a mount substrate (10);
an optoelectronic device (12) on the mount substrate (10);
a spacer layer (20) on the mount substrate (10);
a sealer layer (30) on the spacer layer (20);
wherein the spacer layer (20) includes a hole (24) exposing the optoelectronic device (12), and
the sealer layer (30) covers the hole (24),
the mount substrate (10), the spacer layer (20) and the sealer layer (30) together hermetically sealing the optoelectronic device (12),
**characterized in that** a metallised trench (18) in the mount substrate (10) extends from the optoelectronic device (12) to an edge of the mount substrate (10), a cross-section of the metallised trench (18) at the edge of the mount substrate (10) being exposed, and
the metallised trench (18) provides external electrical contact for the optoelectronic device (12) outside the sealing.

2. The optical apparatus as claimed in claim 1, wherein the mount substrate (10) and the spacer layer (20) are joined in a horizontal layer.

3. The optical apparatus as claimed in claim 1, further comprising a ledge (15) formed in the mount substrate (10) extending beyond the spacer layer (20), the metallised trenche (18) being in the ledge (15).

4. The optical apparatus as claimed in claim 1, wherein the metallised trench (15) is wider near the edge of the mount substrate (10) than between the edge and the optoelectronic device (12).

5. The optical apparatus as claimed in claim 1, further comprising an optics substrate (40) secured to the sealer layer (30), the optics substrate (40) including at least one optical element (44) in optical communication with the optoelectronic device (12).

6. The optical apparatus as claimed in claim 1, further comprising an isolator stack (140) on the cover layer (130).

7. The optical apparatus as claimed in claim 6, wherein the isolator stack (140) is smaller than the cover layer (130).

8. The optical apparatus as claimed in claim 1, further comprising a diffractive optical element (44) on the optics layer (40).

9. The optical apparatus as claimed in claim 1, wherein the mount substrate (10) extends further in at least one direction than the spacer layer (20) so as to form a ledge (15).

10. The optical apparatus as claimed in claim 1, further comprising an optical coupling element (42) on an outer surface of the optics layer (40).

11. The optical apparatus as claimed in claim 10, further comprising a mating feature (43) surrounding the optical coupling element (42).

12. The optical apparatus as claimed in claim 11, wherein the mating feature (43) extends further from the outer surface of the optics layer (40) than the coupling element (42).

13. The optical apparatus as claimed in claim 1, further comprising a mating feature (43) on a terminal surface of the optical apparatus.

## Patentansprüche

1. Optische Vorrichtung mit:
einem Trägersubstrat (10);
einer auf dem Trägersubstrat (10) angeordneten optoelektrischen Vorrichtung (12);
einer auf dem Trägersubstrat (10) angeordneten Abstandsschicht (20);
einer auf der Abstandsschicht (20) angeordneten Dichtungsschicht (30);
wobei die Abstandsschicht (20) ein Loch (24) aufweist, über das die optoelektrische Vorrichtung (12) exponiert ist, und
die Dichtungsschicht (30) das Loch (24) bedeckt,
wobei das Trägersubstrat (10), die Abstandsschicht (20) und die Dichtungsschicht (30) zusammen die optoelektrische Vorrichtung (12) hermetisch abdichten,
**dadurch gekennzeichnet, dass** ein in dem Trägersubstrat (10) ausgebildeter metallisierter Graben (18) von der optoelektrischen Vorrichtung (12) zu einem Rand des Trägersubstrats (10) verläuft, wobei ein am Rand des Trägersubstrats (10) gelegener Querschnittsbereich des metallisierten Grabens (18) exponiert ist, und
der metallisierte Graben (18) einen externen elektrischen Kontakt mit der optoelektrischen Vorrichtung (12) außerhalb der Abdichtung ermöglicht.

2. Optische Vorrichtung nach Anspruch 1, bei der das Trägersubstrat (10) und die Abstandsschicht (20) in einer horizontalen Schicht miteinander verbunden sind.

3. Optische Vorrichtung nach Anspruch 1, ferner mit einem an dem Trägersubstrat (10) ausgebildeten Absatz (15), der über die Abstandsschicht (20) vorsteht, wobei die metallisierten Gräben (18) in dem Absatz (15) angeordnet sind.

4. Optische Vorrichtung nach Anspruch 1, bei der der metallisierte Graben (18) nahe dem Rand des Trägersubstrats (10) breiter ist als zwischen dem Rand und der optoelektrischen Vorrichtung (12).

5. Optische Vorrichtung nach Anspruch 1, ferner mit einem optischen Substrat (40), das an der Dichtungsschicht (30) befestigt ist, wobei das optische Substrat (40) mindestens ein optisches Element (44) aufweist, das sich in optischer Verbindung mit der optoelektrischen Vorrichtung (12) befindet.

6. Optische Vorrichtung nach Anspruch 1, ferner mit einem Isolierer-Stapel (140) auf der Deckschicht (130).

7. Optische Vorrichtung nach Anspruch 6, bei der der Isolierer-Stapel (140) schmaler ist als die Deckschicht (130).

8. Optische Vorrichtung nach Anspruch 1, ferner mit einem diffraktiven optischen Element (44) auf der optischen Schicht (40).

9. Optische Vorrichtung nach Anspruch 1, bei der sich das Trägersubstrat (10) in mindestens einer Richtung weiter erstreckt als die Abstandsschicht (20), um einen Absatz (15) zu bilden.

10. Optische Vorrichtung nach Anspruch 1, ferner mit einem optischen Kopplungselement (42) an einer Außenfläche der optischen Schicht (40).

11. Optische Vorrichtung nach Anspruch 10, ferner mit einem das optische Kopplungselement (42) umgebenden Zusammengriffsmerkmal (43).

12. Optische Vorrichtung nach Anspruch 11, bei dem das Zusammengriffsmerkmal (43) weiter von der Außenfläche der optischen Schicht (40) absteht als das Kopplungselement (42).

13. Optische Vorrichtung nach Anspruch 1, ferner mit einem Zusammengriffsmerkmal (43) an einer Anschlussfläche der optischen Vorrichtung.

## Revendications

1. Un appareil optique, comprenant :
un substrat de fixation (10) :
un dispositif optoélectronique (12) sur le substrat de fixation (10) ;
une couche d'espacement (20) sur le substrat de fixation (10) ;
une couche d'étanchéité (30) sur la couche d'espacement (20) ;
dans lequel la couche d'espacement (20) comprend un trou (24) exposant le dispositif optoélectronique (12), et
la couche d'étanchéité (30) couvre le trou (24),
le substrat de fixation (10), la couche d'espacement (20) et la couche d'étanchéité (30) scellant ensemble hermétiquement le dispositif optoélectronique (12),
**caractérisé en ce qu'**une tranchée métallisée (18) dans le substrat de fixation s'étend du dispositif optoélectronique (12) vers un bord du substrat de fixation (10), une section transversale de la tranchée métallisée (18) sur le bord du substrat de fixation (10) étant exposée, et
la tranchée métallisée (18) assure un contact électrique externe pour le dispositif optoélectronique (12) à l'extérieur du scellement.

2. L'appareil optique selon la revendication 1, dans lequel le substrat de fixation (10) et la couche d'espacement (20) sont assemblés dans une couche horizontale.

3. L'appareil optique selon la revendication 1, comprenant en outre un rebord (15) formé dans le substrat de fixation (10) s'étendant au-delà de la couche d'espacement (20), les tranchées métallisées (18) se trouvant dans le rebord (15).

4. L'appareil optique selon la revendication 1, dans lequel la tranchée métallisée (15) est plus large à proximité du bord du substrat de fixation (10) qu'entre le bord et le dispositif optoélectronique (12).

5. L'appareil optique selon la revendication 1, comprenant en outre un substrat optique (40) fixé à la couche d'étanchéité (30), le substrat optique (40) comprenant au moins un élément optique (44) en communication optique avec le dispositif optoélectronique (12).

6. L'appareil optique selon la revendication 1, comprenant en outre une pile isolante (140) formant isolateur sur la couche de couverture (130).

7. L'appareil optique selon la revendication 6, dans lequel la pile isolante (140) formant isolateur est plus petite que la couche de couverture (130).

8. L'appareil optique selon la revendication 1, comprenant en outre un élément optique de diffraction (44) sur la couche optique (40).

9. L'appareil optique selon la revendication 1, dans lequel le substrat de fixation (10) s'étend plus loin dans au moins une direction que la couche d'espacement (20), de sorte à former un rebord (15).

10. L'appareil optique selon la revendication 1, comprenant en outre un élément de couplage optique (42) sur une surface externe de la couche optique (40).

11. L'appareil optique selon la revendication 10, comprenant en outre une structure d'accouplement mécanique (43) entourant l'élément de couplage optique (42).

12. L'appareil optique selon la revendication 11, dans lequel la structure d'accouplement mécanique (43) s'étend au-delà de la surface extérieure de la couche optique (40) que l'élément de couplage (42).

13. L'appareil optique selon la revendication 1, comprenant en outre une structure d'accouplement mécanique (43) sur une surface terminale de l'appareil optique.
